Europäisches Patentamt

European Patent Office

Office européen des brevets

(19)

(11) Veröffentlichungsnummer : **0 011 686**
**B1**

# (12) EUROPÄISCHE PATENTSCHRIFT

(45) Veröffentlichungstag der Patentschrift :
26.01.83

(21) Anmeldenummer : 79103204.8

(22) Anmeldetag : 29.08.79

(51) Int. Cl.³ : **G 11 C 11/34**, G 11 C 11/24,
H 01 L 27/10

(54) Hochintegrierbares dynamisches Speicherelement und Verfahren zu seinem Betrieb.

(30) Priorität : 29.09.78 DE 2842588

(43) Veröffentlichungstag der Anmeldung :
11.06.80 Patentblatt 80/12

(45) Bekanntmachung des Hinweises auf die Patenterteilung : 26.01.83 Patentblatt 83/04

(84) Benannte Vertragsstaaten :
FR GB NL

(56) Entgegenhaltungen :
DE A 2 730 202
FR A 2 105 251
FR A 2 144 904
FR A 2 326 761
US A 3 852 800
US A 3 893 146
US A 3 999 207

IEEE JOURNAL OF SOLID-STATE CIRCUITS, Vol.
SC11, Nr. 1, Februar 1976, New York, USA, JES-
PERS et al. : « Three-terminal charge-injection
device », Seiten 133-139.
IEEE JOURNAL OF SOLID-STATE CIRCUITS,
Vol. SC12, Nr. 5, Oktober 1977, New York, USA,
KOCH et al. : « Three-terminal CID as RAM cell »,
Seiten 534-536.
IBM TECHNICAL DISCLOSURE BULLETIN,
Vol. 16, Nr. 10, März 1974, Armonk, US, NOBLE :
« Buik access-surface storage memory cells »,
Seiten 3 170-3 172.

(73) Patentinhaber : SIEMENS AKTIENGESELLSCHAFT
Berlin und München Wittelsbacherplatz 2
D-8000 München 2 (DE)

(72) Erfinder : Knauer, Karl, Dipl.-Ing.
Am Dachsberg 13
D-8011 Kirchseeon (DE)

(56) Entgegenhaltungen :
IEEE JOURNAL OF SOLID-STATE CIRCUITS,
Vol. SC11, Nr. 1, Februar 1976, New York, US,
TASCH et al. : « The charge-coupled RAM cell
concept », Seiten 58-63.
IBM TECHNICAL DISCLOSURE BULLETIN,
Vol. 17, Nr. 3, August 1974, Armonk, US, KAL-
TER : « Nondestructive read-out memory », Seiten 790-791.
IEEE TRANSACTIONS ON ELECTRON DEVICES,
Vol. ED-26, Nr. 6, Juni 1979, New York, US,
GRASSL et al. : « The 3 T-CID cell a memory cell
for high-density dynamic RAM's », Seiten 865-
870.

# Hochintegrierbares, dynamisches Speicherelement und Verfahren zu seinem Betrieb

Die Erfindung bezieht sich auf ein dynamisches Speicherelement nach dem Oberbegriff des Anspruchs 1.

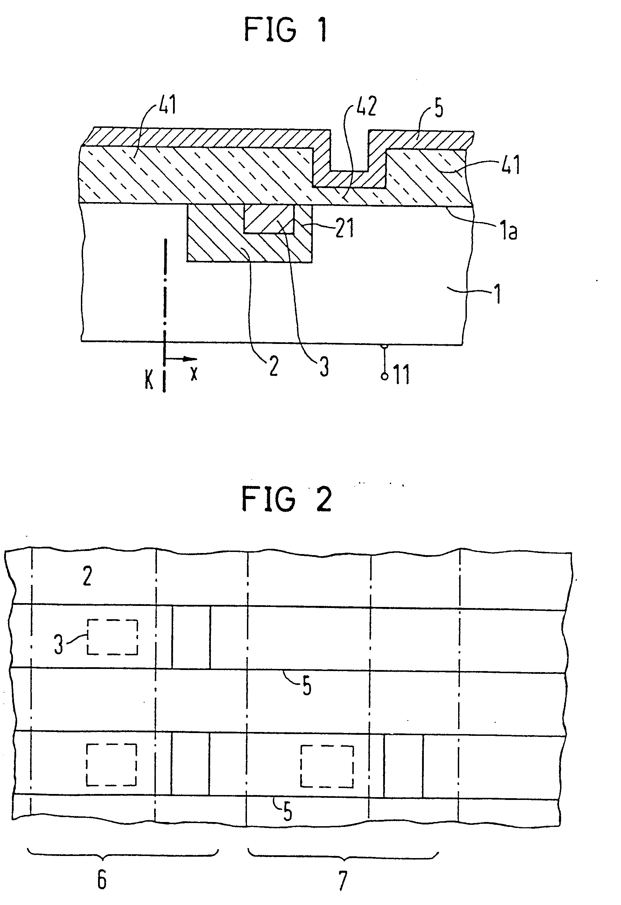

Ein Speicherelement dieser Gattung ist aus dem IEEE Journal of Solid-State Circuits, Vol. SC-11, Nr. 1, Februar 1976, Tasch, « The Charge-Coupled RAM Cell Concept », Seiten 58-63, insb. Fig. 2a, bekannt. Dabei ist der neben dem streifenförmigen Halbleitergebietliegende Halbleiterbereich, der durch einen Dünnschichtbereich der Isolierschicht von der die zweite Ansteuerleitung bildenden Leiterbahn getrennt ist, in einem ersten Teilbereich mit einer oberflächenseitigen Dotierung versehen, die die Grunddotierung des Halbleitersubstrats verstärkt. In einem sich anschließenden, zweiten Teilbereich weist der genannte Halbleiterbereich lediglich die Grunddotierung des Halbleitersubstrats auf. Der erste Teilbereich liegt neben dem streifenförmigen Halbleitergebiet und stellt einen Transferbereich dar, während der zweite Teilbereich, der von dem streifenförmigen Halbleitergebiet durch den ersten Teilbereich getrennt ist, einen Speicherbereich bildet.

Andererseits ist aus der DE-A-2 730 202 ein dynamisches Speicherelement bekannt, das im wesentlichen den Merkmalen des Gattungsbegriffes des Anspruchs 1 entspricht, jedoch mit dem Unterschied, daß der Halbleiterbereich, der von der Leiterbahn durch einen Dünnschichtbereich der Isolierschicht getrennt ist, nicht neben dem streifenförmigen Halbleitergebiet liegt, sondern im Abstand zu diesem angeordnet ist. Bei diesem Speicherelement bildet das Halbleitersubstrat den Source- bzw. Drainbereich eines Feldeffekttransistors, während das streifenförmige Halbleitergebiet einen oberflächenseitigen Kanalbereich darstellt. Ein in das streifenförmige Halbleitergebiet eingefügtes, inselförmiges Halbleitergebiet bildet den Drain- bzw. Sourcebereich des Feldeffekttransistors, der mit der Gateelektrode desselben verbunden ist. Über dieser und durch eine elektrisch isolierende Schicht von dieser getrennt ist die genannte Leiterbahn angeordnet, die zusammen mit der Gateelektrode und der elektrisch isolierenden Schicht eine Speicherkapazität darstellt.

Der Erfindung liegt die Aufgabe zugrunde, ein Speicherelement der eingangs genannten Art mit möglichst kleinen Abmessungen und einfachem Aufbau vorzusehen. Diese Aufgabe wird durch eine Ausbildung des Speicherelements entsprechend den im kennzeichnenden Teil des Anspruchs 1 angeführten Merkmalen gelöst. Der Anspruch 2 hat eine Anordnung mehrerer solcher Speicherelemente im Rahmen einer Speichermatrix zum Gegenstand, während die Ansprüche 3 bis 5 auf Verfahren zum Betrieb eines erfindungsgemäßen Speicherelements gerichtet sind.

Der mit der Erfindung erzielbare Vorteil liegt insbesondere darin, daß der Aufbau des Speicherelements sehr einfach ist und sich für eine hochintegrierte Anordnung einer Mehrzahl von Speicherelementen im Rahmen einer Speichermatrix besonders eignet.

Die Erfindung wird nachfolgend an Hand eines in der Zeichnung dargestellten, bevorzugten Ausführungsbeispiels näher erläutert. Dabei zeigen :

Figur 1 einen Querschnitt durch ein Speicherelement nach der Erfindung,

Figur 2 eine Draufsicht auf das Speicherelement nach Fig. 1, und

Figuren 3 bis 12 Potentialverläufe in dem Speicherelement nach Fig. 1 bei verschiedenen Betriebszuständen.

In Fig. 1 bezeichnet 1 ein Halbleitersubstrat, auf dem ein erfindungsgemäß ausgebildetes Speicherelement aufgebaut ist. Das Substrat besteht beispielsweise aus p-dotiertem Silizium und weist einen Substratanschluß 11 auf. An der Begrenzungsfläche 1a des Substrats 1 befindet sich ein umdotiertes, streifenförmiges Halbleitergebiet 2, das im vorliegenden Fall n-dotiert ist. Dieses n-dotierte Gebiet erstreckt sich senkrecht zur Zeichenebene durch das Substrat 1 hindurch und stellt eine erste Ansteuerleitung des erfindungsgemäßen Speicherelements dar. In dem Gebiet 2 ist in der aus Fig. 1 ersichtlichen Weise ein p-dotiertes, inselförmiges Gebiet 3 vorgesehen. Dabei ist das Gebiet 3 so in dem Gebiet 2 angeordnet, daß es mit seiner in Fig. 1 rechten Begrenzungsfläche der rechtsseitigen Begrenzungsfläche des Gebiets 2 stark angenähert ist. Der Abstand zwischen den beiden Begrenzungsflächen beträgt beispielsweise 0,5 µm. Auf dem Halbleitersubstrat 1, dem n-dotierten Gebiet 2 und dem p-dotierten Gebiet 3 ist eine Isolierschicht, die vorzugsweise aus Siliziumdioxid besteht, angeordnet. Dabei enthält diese Isolierschicht oberhalb eines seitlich an den n-dotierten Bereich 2 angrenzenden Halbleiterbereiches einen Dünnschichtbereich 42. Die restlichen Bereiche der Isolierschicht sind als Dickschichtbereiche 41 ausgebildet. Beispielsweise beträgt die Dicke des Dünnschichtbereiches 42 etwa 60 nm und die Dicke der Dickschichtbereiche 41 etwa 0,6 µm. Auf der Isolierschicht 41, 42 verläuft eine Leiterbahn 5, die vorzugsweise aus Aluminium besteht. Die Tiefe des Gebietes 2 kann mit 2 µm angenommen werden, die Tiefe des Gebietes 3 mit 1 µm. Die Breite des Gebietes 2 beträgt z.B. 10 µm, die Breite des Gebietes 3 etwa 3 bis 5 µm.

In Fig. 2 ist eine Draufsicht auf die Anordnung nach Fig. 1 dargestellt. Einzelheiten der Fig. 1, die bereits beschrieben wurden, tragen in Fig. 2 die gleichen Bezugszeichen. Eine strichpunktiert eingegrenzte Bahn stellt das in Fig. 2 vertikal verlaufende, streifenförmige Gebiet 2 bzw. eine erste Ansteuerleitung dar, strichliert eingerahmte Flächen geben die Gebiete 3 an und Flächen, die von einer durchgezogenen Linie umrandet sind, Leiterbahnen 5, die die zweiten Ansteuerleitungen darstellen. In der Fig. 2 ist ein zweites Speicherelement 6 dargestellt, das in entsprechender Weise wie das in Fig. 1 dargestellte Speicherelement mit ein und derselben ersten Ansteuerleitung 2 verbunden ist. Ein drittes, rechts neben dem zweiten Element 6 angeordnetes Speicherelement ist in Fig. 2 mit 7 bezeichnet.

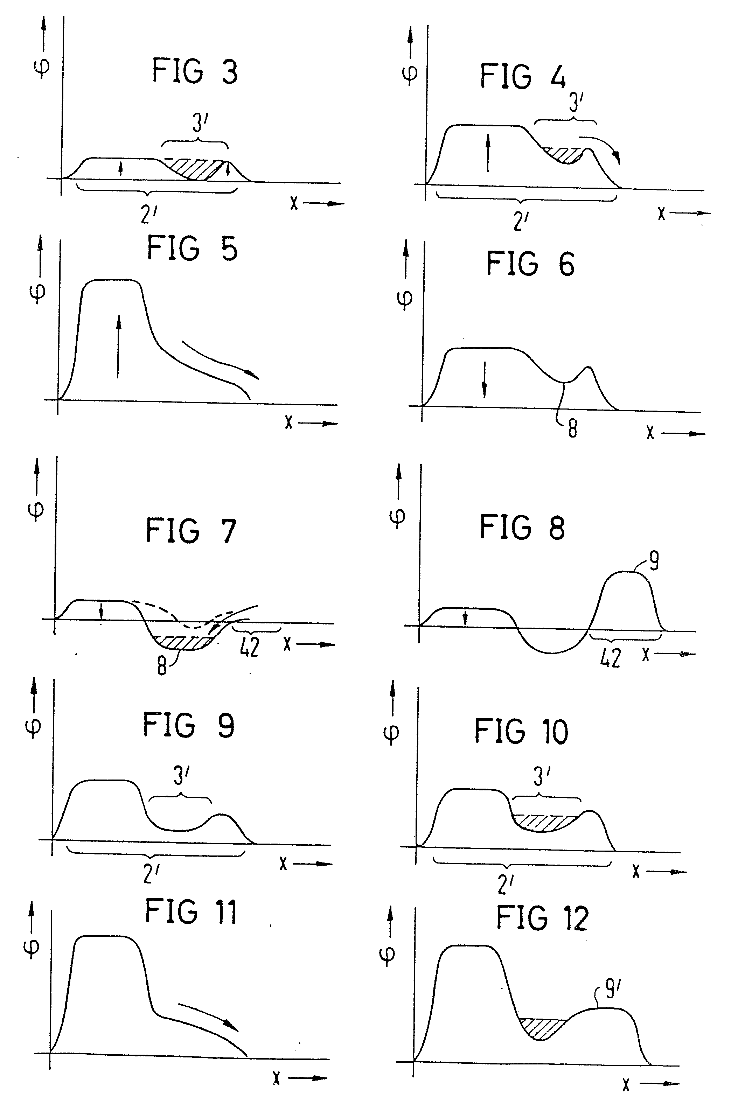

Im folgenden sollen nun anhand der Figuren 3 bis 14 einige Betriebsverfahren für das erfindungsgemäße Speicherelement beschrieben werden. Zunächst wird durch Anlegen einer positiven Vorspannung an das streifenförmige Halbleitergebiet 2 dieses bezüglich der Majoritätsladungsträger verarmt. In Fig. 3 sind die dabei entstehenden Potentialverhältnisse dargestellt. Dabei bedeutet $\varphi$ das Oberflächenpotential an der Begrenzungsfläche 1a, während x die in Fig. 1 eingezeichnete Entfernung von einer strichpunktierten Bezugslinie K bedeutet. Mit 2' und 3' sind die in Richtung x gemessenen Breiten der Bereiche 2 und 3 gekennzeichnet. Solange in dem Teilbereich 21 des n-dotierten Gebiets 2 noch Majoritätsladungsträger vorhanden sind, wird das Potential $\varphi$ des Gebiets 2 gleichmäßig angehoben, was in Fig. 3 durch zwei Pfeile angedeutet ist. Sind in dem dünnen Bereich 21 keine Ladungsträger mehr vorhanden und wird das Potential des Gebiets 2 weiter angehoben, so entsteht ein Spannungsabfall zwischen den links und rechts vom Gebiet 3 liegenden Teilbereichen des Gebiets 2 (Fig. 4). Es kann nun Ladung aus dem p-dotierten Gebiet 3 in das Substrat 1 abfließen. Dieser Vorgang wird so lange fortgesetzt, bis keine Ladung mehr in dem p-Gebiet 3 enthalten ist. Dieser Zustand ist in Fig. 5 dargestellt. Wird nun das Potential des n-Gebiets 2 bzw. der ersten Ansteuerleitung wieder abgesenkt, so bildet sich in dem p-Gebiet 3 eine Potentialsenke 8 (Fig. 6).

Wenn man das Potential in den n-Gebiet 2 entsprechend Fig. 7 weit genug absenkt, wird durch die Potentialsenke 8 Ladung aus dem Substrat 1 über den Teilbereich 21 in das p-Gebiet 3 gezogen. Um diese Ladungseingabe lediglich beim Einschreiben eines ersten logischen Zustands, z.B. « O », erfolgen zu lassen, beim Einschreiben des zweiten logischen Zustands, z.B. « 1 », dagegen nicht, wird im ersteren Fall (Fig. 7) an die Leiterbahn 5 eine kleine positive Spannung angelegt, die unterhalb des Bereiches 42 noch keine Potentialschwelle entstehen läßt, im letzteren Fall eine größere positive Spannung, die eine Potentialschwelle 9 erzeugt (Fig. 8).

Anschließend wird das Gebiet 2 auf so ein positives Potential gelegt, daß einerseits keine Ladung aus dem Substrat 1 in das leere p-Gebiet 3 gezogen wird, (Fig. 9), oder daß andererseits keine Ladung aus dem mit Ladung belegten p-Gebiet 3 abfließen kann (Fig. 10). Damit ist der Einschreibvorgang an einem Speicherelement beendet.

Beim Auslesen sind mehrere Möglichkeiten zu unterscheiden. Es soll zunächst ein Verfahren beschrieben werden, das angewendet wird, um ein einzelnes Element aus einer Mehrzahl von zeilen- und spaltenweise zusammengefaßten Elementen auszulesen. In einer so gebildeten Matrix wird zu diesem Zweck an alle Leiterbahnen 5, abgesehen von der über dem auszulesenden Element angeordneten Leiterbahn 5, eine positive Spannung angelegt. Es wird dann die Spannung des zugeordneten Gebiets 2 angehoben. Befindet sich in dem betreffenden p-Gebiet 3 Ladung, so fließt diese in das Substrat 1 ab (Fig. 11). Die Ladungen aller anderen Inseln 3 desselben Gebiets 2 werden durch die Potentialschwellen 9', die durch die Leiterbahnen 5 erzeugt werden, am Ausfließen gehindert (Fig. 12). Die ausfließende Ladung kann nun am Substratkontakt 11 festgestellt werden, wie dies von CID-Anordnungen her bekannt ist.

Ein anderes Verfahren zum Auslesen der gespeicherten Information besteht darin, den Strom an der betreffenden ersten Ansteuerleitung auszuwerten. Wenn in dem p-Gebiet 3 Ladung gespeichert wurde, so ist in dem streifenförmigen Gebiet 2 ebenfalls eine entsprechende Ladung vorhanden, die beim Auslesen frei wird. An der ersten Ansteuerleitung entsteht dabei ein Stromsignal, das in bekannter Weise ausgewertet werden kann. Hierbei können auch sämtliche ersten Ansteuerleitungen einer Mehrzahl von in einer Zeile angeordneten Speicherelementen gleichzeitig ausgewertet werden, was einer gleichzeitigen Auslesung aller Speicherelemente dieser Zeile entspricht.

Wählt man die Breite des Gebiets 2, die in Fig. 1 sichtbare Breite des Bereichs 42, die Breite der Leiterbahnen 5 und deren gegenseitigen Abstand zu jeweils 5 $\mu$m, so ergibt sich für ein Speicherelement ein Flächenbedarf von etwa 51 $\mu$m².

## Ansprüche

1. Dynamisches Speicherelement mit einem dotierten Halbleitersubstrat (1), das mit einem Substratanschluß (11) versehen ist, mit einer eine Begrenzungsfläche (1a) des Substrats (1) abdeckenden Isolierschicht, die Dickschichtbereiche (41) und Dünnschichtbereiche (42) aufweist, mit einem entgegengesetzt zum Substrat (1) dotierten, streifenförmigen Halbleitergebiet (2), das als eine parallel zu der Begrenzungsfläche (1a) verlaufende, erste Ansteuerleitung ausgebildet ist, und mit einer als eine zweite Ansteuerleitung ausgebildeten, auf der Isolierschicht angeordneten und quer zur ersten Ansteuerleitung verlaufenden Leiterbahn (5), die von einem neben dem streifenförmigen Halbleitergebiet (2) liegenden Halbleiterbereich durch einen Dünnschichtbereich (42) getrennt ist, dadurch gekennzeichnet, daß innerhalb des streifenförmigen Halbleitergebietes (2) ein entgegengesetzt zu diesem dotiertes, inselförmiges Halbleitergebiet (3) angeordnet ist und daß dieses letztere Halbleitergebiet (3) derjenigen Grenzfläche des streifenförmigen Halbleitergebietes (2), die dieses von dem unterhalb des Dünnschichtbereiches (42) liegenden Halbleiterbereich trennt, wesentlich stärker angenähert ist als der dieser gegenüberliegenden Grenzfläche des streifenförmigen Halbleitergebietes (2).

2. Speicherelement nach Anspruch 1, dadurch gekennzeichnet, daß es zusammen mit gleichartigen Speicherelementen in Zeilen und Spalten angeordnet ist, daß die Speicherelemente einer Spalte jeweils ein gemeinsames, streifenförmiges Halbleitergebiet (2) aufweisen und daß die Speicherelemente einer Zeile jeweils eine gemeinsame Leiterbahn (5) aufweisen. St 1 Wi-05.01.1982

3. Verfahren zum Betrieb eines Speicherelements nach Anspruch 1 oder 2, dadurch gekennzeichnet, daß das Einschreiben von Information dadurch vorbereitet wird, daß das streifenförmige Halbleitergebiet (2) durch Anlegen einer Vorspannung zunächst bezüglich der Majoritätsladungsträger verarmt wird, daß das Potential des streifenförmigen Halbleitergebiets (2) anschließend weiter erhöht wird, bis die Majoritätsladungsträger aus dem inselförmigen Halbleitergebiet (3) in das Substrat (1) abgeflossen sind, und daß schließlich das Potential des streifenförmigen Halbleitergebiets (2) wieder soweit abgesenkt wird, daß in dem inselförmigen Halbleitergebiet (3) eine Potentialsenke (8) entsteht, daß zum Einschreiben einer digitalen Information erster Art ein Absenken des Potentials des streifenförmigen Halbleitergebiets (2) erfolgt, wobei an die Leiterbahn (5) eine so niedrige Spannung gelegt ist, daß Majoritätsladungsträger aus dem Substrat (1) über den von dem Dünnschichtbereich (42) überdeckten Halbleiterbereich in das inselförmige Halbleitergebiet (3) einfließen, daß zum Einschreiben einer digitalen Information zweiter Art ein Absenken des Potentials des streifenförmigen Halbleitergebiets (2) erfolgt, wobei an die Leiterbahn (5) eine so hohe Spannung gelegt ist, daß unterhalb des Dünnschichtbereiches (42) eine Potentialschwelle (9) entsteht, die ein Einfließen von Majoritätsladungsträgern aus dem Substrat (1) in das inselförmige Halbleitergebiet (3) verhindert, und daß zur Speicherung der eingeschriebenen Information das Potential des streifenförmigen Halbleitergebiets (2) wieder soweit angehoben wird, daß kein Ladungsaustausch zwischen dem inselförmigen Halbleitergebiet (3) und dem Substrat (1) erfolgt.

4. Verfahren nach Anspruch 3, dadurch gekennzeichnet, daß zum Auslesen der gespeicherten Information eine niedrige Spannung an der Leiterbahn (5) liegt und daß das Potential des streifenförmigen Halbleitergebiets (2) soweit angehoben wird, daß eine gegebenenfalls in dem inselförmigen Halbleitergebiet (3) vorhandene Ladung in das Substrat abfließt (1) und in Form einer Potentialänderung am Substratanschluß (11) ausgewertet wird.

5. Verfahren nach Anspruch 3, dadurch gekennzeichnet, daß zum Auslesen der gespeicherten Information eine niedrige Spannung an der Leiterbahn (5) liegt und daß das Potential des streifenförmigen Halbleitergebiets (2) soweit angehoben wird, daß eine gegebenenfalls in dem inselförmigen Halbleitergebiet (3) vorhandene Ladung in das Substrat (1) abfließt und eine bei einem solchen Abfließen entstehende Potentialänderung in dem streifenförmigen Halbleitergebiet (2) ausgewertet wird.

**Claims**

1. A dynamic storage element comprising a doped semiconductor substrate (1) which is provided with a substrate terminal (11), with an insulating layer which covers a boundary surface (1a) of the substrate (1) and has thick layer regions (41) and thin layer regions (42), with a strip-shaped semi-conductor zone (2) which is oppositely doped to the substrate (1) and forms a first control line running parallel to the boundary surface (1a), and with a conductor path (5) which forms a second control line and is arranged on the insulating layer, runs transversely to the first control line and is separated from a semiconductor zone arranged beside the strip-shaped semiconductor zone (2) by a thin layer region (42), characterised in that within the strip-shaped semiconductor zone (2), there is arranged an oppositely-doped island-shaped semiconductor zone (3), said semiconductor zone (3) being substantially closer to the boundary surface of the strip-shaped semiconductor zone (2), which separates the latter from the semiconductor region below the thin layer region (42), than to the opposite boundary surface of the strip-shaped semiconductor zone (2).

2. A storage element as claimed in Claim 1, characterised in that the storage element together with similar storage elements is arranged in rows or columns, that the storage elements of a column have a common, strip-shaped semiconductor zone (2), and that the storage elements of a row have a common conductor path (5).

3. A method of operating a storage element as claimed in Claim 1 or Claim 2, characterised in that the write-in of information is enabled by first depleting the strip-shaped semiconductor zone (2) in respect of the majority charge carriers by applying a bias voltage thereto, subsequently further increasing the potential of the strip-shaped semiconductor zone (2) until the majority charge carriers have flowed from the island-shaped semiconductor zone (3) into the substrate (1), and finally lowering the potential of the strip-shaped semiconductor zone (2) so that a potential trough (8) is formed in the island-shaped semiconductor zone (3) ; that in order to write-in an item of digital information of a first type, a reduction of the potential of the strip-shaped semi-conductor zone (2) takes place, whereat a voltage is applied to the conductor path (5) which is so low that majority charge carriers flow from the substrate (1) into the island-shaped semiconductor zone (3) via the semiconductor region which is covered by the thin layer region (42) ; that in order to write-in an item of digital information of a second type, a reduction of the potential of the strip-shaped semiconductor zone (2) takes place, whereat a voltage is applied to the conductor path (5) which is so high that a potential threshold (9), which prevents the majority charge carriers from flowing from the substrate (1) into the island-shaped semiconductor zone (3), is formed below the thin layer region (42) ; and that in order to store the written-in information, the potential of the strip-shaped semiconductor zone (2) is raised to such an extent that no charge exchange takes place between the island-shaped semiconductor zone (3) and the substrate (1).

4. A method as claimed in Claim 3, characterised in that in order to read out the sotred information, a low voltage is applied to the conductor path (5), and that the potential of the strip-shaped semiconductor zone (2) is raised to such an extent that in the event that a charge is present in the island-shaped semiconductor zone (3), it flows into the substrate (1) and is evaluated at the substrate terminal (11) in the form of a change in potential.

5. A method as claimed in Claim 3, characterised in that in order to read out the stored information, a low voltage is applied to the conductor path (5), and that the potential of the strip-shaped semiconductor zone (2) is raised to such an extent that in the event that a charge is present in the island-shaped semiconductor zone (3), it flows into the substrate (1), and a change in potential occurring in the event of such a flow in the strip-shaped semiconductor zone (2) is evaluated.

**Revendications**

1. Elément de mémoire dynamique comportant un substrat semiconducteur dopé (1) qui est muni d'une borne (11) de substrat, une couche isolante recouvrant une surface de délimitation (1a) du substrat (1), qui comprend des zones de couche épaisse (41) et des zones de couche mince (42), une zone semiconductrice (2) en forme de bande dopée de façon opposée par rapport au substrat (1), qui se présente sous la forme d'une première ligne de commande s'étendant parallèlement à la surface de délimitation (1a), ainsi qu'une voie conductrice (5), se présentant sous la forme d'une seconde ligne de commande, disposée sur la couche isolante et s'étendant transversalement par rapport à la première ligne de commande, qui est séparée d'une zone semiconductrice située à côté de la zone semiconductrice (2) en forme de bande, par une zone de couche mince (42), caractérisé par le fait qu'à l'intérieur de la zone semiconductrice (2) en forme de bande est disposée une zone semiconductrice (3) en forme d'îlot dopée de façon opposée par rapport à celle-ci, et que cette dernière zone semiconductrice (3) de la surface de délimitation de la zone semiconductrice (2) en forme de bande qui la sépare de la zone semiconductrice se trouvant sous la zone de couche mince (42), est nettement plus rapprochée que la surface de délimitation opposée de la zone semiconductrice (2) en forme de bande.

2. Elément de mémoire suivant la revendication 1, caractérisé par le fait qu'il est agencé en lignes et en colonnes avec des éléments de mémoire de même type, que les éléments de mémoire d'une colonne possèdent respectivement une zone semiconductrice (2) en forme de bande commune, et que les éléments de mémoire d'une ligne possèdent respectivement une voie conductrice commune (5).

3. Procédé pour la mise en œuvre d'un élément de mémoire suivant l'une des revendications 1 ou 2, caractérisé par le fait que l'inscription d'une information est préparée du fait que la zone semiconductrice (2) en forme de bande est tout d'abord appauvrie en porteurs de charge majoritaires, par application d'une tension de polarisation, que le potentiel de la zone semiconductrice (2) en forme de bande est ensuite augmenté jusqu'à ce que les porteurs de charge majoritaires soient écoulés dans le substrat (1) à partir de la zone semiconductrice (3) en forme d'îlot, et qu'enfin le potentiel de la zone semiconductrice (2) en forme de bande est de nouveau diminué jusqu'à ce que dans la zone semiconductrice (3) en forme d'îlot apparaisse un puits de potentiel (8), que pour inscrire l'information numérique d'un premier type de potentiel de la zone semiconductrice (2) en forme de bande est diminuée, ce qui applique à la voie conductrice (3) une tension suffisamment faible pour que des porteurs de charge majoritaires provenant du substrat (1) arrivent dans la zone semiconductrice (3) en forme d'îlots, par l'intermédiaire de la zone semiconductrice recouverte par la zone de couche mince (42), que pour inscrire une information numérique d'un second type le potentiel de la région semiconductrice (2) en forme de bande est diminué, ce qui applique à la voie conductrice (5) une tension suffisamment élevée pour qu'il apparaisse sous la zone de couche mince (42) un seuil de potentiel (9) qui empêche une introduction de porteurs de charge majoritaires dans la zone semiconductrice (3) en forme d'îlots à partir du substrat (1), et que pour la mémorisation des informations inscrites le potentiel de la zone semiconductrice (2) en forme de bande est de nouveau augmenté jusqu'à ce qu'il n'y ait plus d'échange de charge entre la zone semiconductrice (3) en forme d'îlots et le substrat (1).

4. Procédé suivant la revendication 3, caractérisé par le fait que pour lire l'information mémorisée une tension faible est appliquée à la voie conductrice (5), et que le potentiel de la zone semiconductrice (2) en forme de bande est augmenté jusqu'à ce qu'une charge éventuellement présente dans la zone semiconductrice (3) en forme d'îlot s'écoule dans le substrat (1) et soit évaluée sous la forme d'une variation du potentiel au niveau de la borne (11) du substrat.

5. Procédé suivant la revendication 3, caractérisé par le fait que pour lire l'information mémorisée une tension faible est appliquée à la voie conductrice (5), et que le potentiel de la zone semiconductrice (2) en forme de bande est augmenté jusqu'à ce qu'une charge existant éventuellement dans la zone semiconductrice (3) en forme d'îlot s'écoule dans le substrat (1) et qu'une variation de potentiel apparaissant lors d'un tel écoulement est évaluée dans la zone semiconductrice (2) en forme de bande.

# FIG 1

# FIG 2

FIG 3

FIG 4

FIG 5

FIG 6

FIG 7

FIG 8

FIG 9

FIG 10

FIG 11

FIG 12